# EUROPEAN PATENT APPLICATION

(11) **EP 1 667 230 A1**
(43) Date of publication of application: **07.06.2006**
(21) Application number: 04787719.6
(22) Date of filing: 08.09.2004
(51) Int. Cl.: H01L 27/10, H01L 45/00, C23C 14/34

(54) **PHASE-CHANGE FILM FOR SEMICONDUCTOR NON-VOLATILE MEMORY AND SPUTTERING TARGET FOR FORMING SUCH PHASE-CHANGE FILM**

(30) Priority: 17.09.2003 JP 2003324063; 31.03.2004 JP 2004102724
(71) Applicant: MITSUBISHI MATERIALS CORPORATION, Chiyoda-ku, Tokyo 100-8117 (JP)
(72) Inventor: Nonaka, S., Sanda Plant Mitsubishi Materials Corp., Sanda-shi, Hyogo 6691339 (JP); Kinoshita, K., Sanda Pl. Mitsubishi Material Corp., Sanda-shi, Hyogo 6691339 (JP); Mori, S., Sanda Plant Mitsubishi Materials Corp., Sanda-shi, Hyogo 6691339 (JP)
(74) Representative: HOFFMANN EITLE
(86) International application number: PCT/JP2004/013036
(87) International publication number: WO 2005/029585

(57) **Abstract**

There are provided a phase change film for a semiconductor nonvolatile memory and a sputtering target for forming the phase change film. The phase change film for a semiconductor nonvolatile memory and the sputtering target for forming the phase change film have a composition containing 10 to 25 atomic% of Ge, 10 to 25 atomic% of Sb, 1 to 10 atomic% of Ga, and 10 atomic % or less of B, Al, C, Si and lanthanoid elements, with the balance being Te and inevitable impurities.

## Description

### Technical Field

The present invention relates to a phase change film for a semiconductor nonvolatile memory and a sputtering target for forming the phase change film.

### Background Art

Phase change films for semiconductor nonvolatile memory (Phase Change RAM or PRAM) has been used as recording layers. A phase change material in a crystalline state is used for the recording layers. In this case, rewrite is performed by rapidly heating and melting a portion of the phase change material with a heater, and then rapidly cooling the portion to make it partially amorphous, or otherwise heating an amorphous portion at a low temperature to bring it back to a crystalline state. Meanwhile, readout is performed due to difference between the electrical resistances of the phase change material in a crystalline state and a partially amorphous state. As one of the phase change films, there is known a phase change film having a composition containing 10 to 25% of Ge and 10 to 25% of Sb, with the balance being Te and inevitable impurities. There is also known a phase change film formed by performing sputtering using a target with almost the same component composition as the above phase-change recording layer (for example, refer to Patent Documents 1 to 3 and Non-Patent Documents 1 and 2).
[Patent Document 1] JP-W No. 2001-502848
[Patent Document 2] JP-W No. 2002-512439
[Patent Document 3] JP-W No. 2002-540605

[Non-Patent Document 1] "Applied Physics", Vol. 71, No. 12, 2002, p. 1513 to 1517
[Non-Patent Document 2] "Nikkei Micro-devices", March issue in 2003, p.104

As disclosed in Non-Patent Document 1, at the time of writing/erasing, it is first necessary to raise the temperature of crystal above a melting point, particularly, in order to change a crystalline state to an amorphous state (reset operation). In this case, if the melting point is high, the value of a current which is allowed to flow through a circuit should be large. As a consequence, the power consumption increases, and large current flow increases the load to a peripheral circuit, thereby to reduce the size of the circuit is prevented.

### Disclosure of the Invention

Therefore, the inventors of the present invention have conducted research to solve such problems. As a result, the following research results were obtained.
(a) When 1 to 10% of Ga is contained in an ordinary phase change film with a composition containing 10 to 25% of Ge and 10 to 25% of Sb, with the balance being Te and inevitable impurities, the melting point can be lowered and the electric resistivity of the film in a crystalline state barely changes. Therefore, the amount of the current needed for melting can be reduced. Thus, the power consumption can be reduced and a burden to a peripheral circuit can be relived.
(b) Further, if B, Al, C, Si or a lanthanoid element is contained 10% or less, the electric resistivity rises, and thus the amount of current needed for melting is further reduced. Accordingly, the power consumption can be reduced.
(c) Among the lanthanoid elements, Dy, Tb, Nd, Sm, and Gd are particularly effective.

The present invention is achieved based on these research results, and is characterized by:
(1) a phase change film for a semiconductor nonvolatile memory with a composition containing 10 to 25 atomic% of Ge, 10 to 25 atomic% of Sb, and 1 to 10 atomic% of Ga, with the balance being Te and inevitable impurities, and
(2) a phase change film for a semiconductor nonvolatile memory with a composition 10 to 25 atomic% of Ge, 10 to 25 atomic% of Sb, 1 to 10 atomic% of Ga, and a total of 10 atomic% or less of at least one or more elements selected from a group consisting of B, A1, C, Si and lanthanoid elements, with the balance being Te and inevitable impurities.
   Among the lanthanoid elements, Dy, Tb, Nd, Sm, and Gd are particularly preferable. Accordingly, the present invention is characterized by:
(3) the phase change film for a semiconductor nonvolatile memory as described in the above (2), in which the lanthanoid elements are at least one or more elements selected from a group consisting of Dy, Tb, Nd, Sm, and Gd.
   In the phase change film for a semiconductor nonvolatile memory described in the above (1) to (3), preferably, the electric resistivity of the film measured by the four-point probe method after crystallization is 5 x 10⁻³ to 5 x 10 Ω·cm, and the melting point of the film is 600°C or less. Accordingly, the present invention is characterized by:
(4) a phase change film for a semiconductor nonvolatile memory described in any one of the above (1) to (3), wherein the electric resistivity of the film measured by the four-point probe method after crystallization is 5 x 10⁻³ to 5 x 10 Ω·cm, and the melting point of the film is 600°C or less.
   The phase change film formed using the sputtering targets of the present invention enables a low melting point to be obtained without remarkably lowering resistance so much, and can reduce a current value at the time of writing operation, contribute to the reduction in power consumption and a miniaturization of devices, and make a great contribution to the development of a new semiconductor memory industry.
   The reasons why the component compositions of the phase change film for a semiconductor nonvolatile memory according to the present invention are limited, as mentioned above, will be described.

### (a) Ga

When Ga component is contained in a phase change film with a composition containing 10 to 25% of Ge and 10 to 25% of Sb, with the balance being Te and inevitable impurities, Ga component has a function to further lower the melting point of the phase change film. However, if less than 1% of Ga is contained, the effect of lowering the melting point is little, which is not preferable. On the other hand, if Ga is contained over 10%, the crystallization temperature rises excessively, which is not preferable. A proper rise in the crystallization temperature improves the stability of an amorphous state which leads to improvement of the retention characteristics. However, if the crystallization temperature rises excessively, the electric power required for crystallization increases, which is not preferable from the viewpoint of reducing power consumption. Accordingly, the amount of Ga to be contained in the phase change film is set to be 1 to 10% (more preferably, 2 to 8%).

In addition, even if 1 to 10% of Ga is contained in the phase change film of a semiconductor nonvolatile memory with a composition containing 10 to 25% of Ge and 10 to 25% of Sb, with the balance being Te and inevitable impurities, the electric resistivity of the film in its crystallized state is not lowered.

Further, the phase change film with a composition containing 10 to 25% of Ge and 10 to 25% of Sb, with the balance being Te and inevitable impurities, has mainly two types of crystal structures, i.e., a face-centered cubic crystal structure having a high resistance and a hexagonal crystal structure having a low resistance. The face-centered cubic crystal structure is created when the film is crystallized at a relatively low temperature, and the hexagonal crystal structure is created when the film is kept at a relatively high temperature. Since the phase change rate from an amorphous state to a face-centered cubic crystal state is rapid, the crystal which is created when the film is phase-changed and crystallized from an amorphous state is generally face-centered cubic crystal. However, if Ga is added to the conventionally known composition of Ge-Sb-Te, the face-centered cubic crystal structure is stabilized up to a high temperature as compared with the case of not adding Ga. Therefore, Ga also has an effect of improving the temperature stability of the electric resistivity.

### (b) B, Al, C, Si, and lanthanoid elements

Because these components have a function to further raise a resistance value in a crystalline state of the phase change film by the addition of Ga, they are added, if necessary. However, if these components are contained over 10%, the rise in the crystallization temperature of the phase change film increases excessively, which is not preferable. A proper rise in the crystallization temperature improves the stability of an amorphous state which leads to improvement of the retention characteristics. However, if the crystallization temperature rises excessively, the electric power required for crystallization increases, which is not preferable from the viewpoint of reducing power consumption. Accordingly, the content of these components are set to be 10% or less. The range of the content is more preferably 0.5 to 8%. In addition, among the lanthanoid elements, Dy, Tb, Nd, Sm, and Gd are particularly preferable.

### (c) Ge, Sb

Ge and Sb contained in the phase change film having a high electrical resistance according to the present invention is preferably 10 to 25% of Ge and 10 to 25% of Sb. The reason is based on the fact that, if Ge is less than 10% and Sb is less than 10% and if Ge is over 25% and Sb is over 25%, the resistance value becomes low and the crystallization time becomes long, which are not preferable.

The phase change film according to the present invention requires the electric resistivity value measured by the four-point probe method after crystallization to be 5 x 10-³ Ω·cm or more (more preferably, 8 x 10⁻² Ω·cm or more). The reason comes from the fact that, if the electric resistivity value is less than 5 x 10⁻³ Ω·cm, a large current flows through a circuit, which therefore increases the power consumption and becomes an obstacle in reducing the size of the circuit, which are not preferable. Further, the electric resistivity of a Ge-Sb-Te alloy in an amorphous state is generally about 1 x 10² Ω·cm. It is preferable that this alloy has a difference of about at least one and a half digits between the resistivities of the alloy in a crystalline state and an amorphous state for stable read-out. Therefore, the resistivity value of the phase change film in a crystalline state is required to be 5 x 10 Ω·cm or less. Accordingly, the electric resistivity measured by the four-point probe method after the crystallization of the phase change film according to the present invention is set to be 5 x 10⁻³ Ω·cm to 5 x 10 Ω · cm. Moreover, the melting point of the phase change film according to the present invention is required to be 600°C from the viewpoint of low power consumption.

A sputtering target for forming a phase change film for a semiconductor nonvolatile memory with the composition, as described in the above (1), according to the present invention, is required to have a component composition containing 10 to 26 atomic% of Ge, 10 to 26 atomic% of Sb, and 1 to 11 atomic% of Ga, with the balance being Te and inevitable impurities.

Further, a sputtering target for forming a phase change film for a semiconductor nonvolatile memory with the composition, as described in the above (2) is required to have a composition 10 to 26 atomic% of Ge, 10 to 26 atomic% of Sb, 1 to 11 atomic% of Ga, and a total of 11 atomic% or less of at least one or more elements selected from a group consisting of B, Al, C, Si and lanthanoid elements, with the balance being Te and inevitable impurities.

Accordingly, the present invention is characterized by
(5) a sputtering target for forming a phase change film for a semiconductor nonvolatile memory with a composition containing 10 to 26 atomic% of Ge, 10 to 26 atomic% of Sb, and 1 to 11 atomic% of Ga, with the balance being Te and inevitable impurities,
(6) a sputtering target for forming a phase change film for a semiconductor nonvolatile memory with a composition 10 to 26 atomic% of Ge, 10 to 26 atomic% of Sb, 1 to 11 atomic% of Ga, and a total of 11 atomic% or less of at least one or more elements selected from a group consisting of B, Al, C, Si and lanthanoid elements, with the balance being Te and inevitable impurities, and
(7) the sputtering target for forming a phase change film for a semiconductor nonvolatile memory as described in the above (6), in which the lanthanoid elements are at least one or more elements selected from a group consisting of Dy, Tb, Nd, Sm, and Gd.

The sputtering target for forming a phase change film for a semiconductor nonvolatile memory having the component composition, as described in above (1), according to the present invention, is manufactured by melting a Ge-Sb-Te based alloy with a predetermined component composition in an Ar gas atmosphere, then adding Ga to the molten metal, pouring the molten metal into molds made of iron to manufacture an alloy ingot, pulverizing the alloy ingot in an inert gas atmosphere to manufacture an alloy powder having a particle size of 200 µm or less, and finally hot pressing the alloy powder in a vacuum. The vacuum hot pressing is performed by keeping the alloy powder under the following conditions: a pressure of 146 to 155 MPa, a temperature of 370 to 430°C, and a duration of 1 to 2 hours, and thereafter cooling the molds to a normal temperature at a cooling rate of 1 to 3°C/min when the temperature of the molds has dropped to 270 to 300°C.

Moreover, the sputtering target for forming a phase change film for a semiconductor nonvolatile memory having the component composition, as described in above (2), according to the present invention, is manufactured by adding Ga to a Ge-Sb-Te based alloy, mixing this alloy powder with one or more of the separately manufactured powders of B, Al, C, Si, and lanthanoid elements (preferably, Dy, Tb, Nd, Sm, and Gd) each having a particle size of 200 µm or less so as to have component compositions according to the present invention, and hot-pressing the alloy powder in a vacuum. The vacuum hot pressing is performed by keeping the alloy powder under the following conditions: a pressure of 146 to 155 MPa, a temperature of 370 to 430°C, and a duration of 1 to 2 hours, and thereafter cooling the molds to a normal temperature at a cooling rate of 1 to 3°C/min when the temperature of the molds has dropped to 270 to 300°C.

### Best Mode for Carrying Out the Invention

Ge, Sb, and Te were melted in an Ar gas atmosphere. Ga was added to the obtained molten metal. An alloy ingot was manufactured by casting the molten metal obtained by adding Ga. An alloy powder having a particle size of 100 µm or less was manufactured by reducing the alloy ingot to powder in an Ar atmosphere. Mixed powders were manufactured by mixing the alloy powder with the respective elemental powders of B, A1, C, Si, Dy, Tb, Nd, Sm, and Gd.

Hot pressed bodies were manufactured by hot-pressing the alloy power and the respective mixed powders in a vacuum at a temperature of 400°C and at a pressure of 146 MPa. Targets 1 to 21 according to the present invention, comparative targets 1 to 10, and conventional target 1 having the following dimensions: a diameter of 125 mm and a thickness of 5 mm, a disk shape, and component compositions as shown in Tables 1 to 3 were manufactured by performing grinding processing on the hot pressed bodies under the condition of a lathe revolution speed of 200 rpm, using a carbide turning tool.

**[Table 1]**

| Target | | Component Composition (Atomic%) | | | | |
|---|---|---|---|---|---|---|
| | | Ge | Sb | Ga | B, Al, C, Si, Lanthanoid Element | Te |
| Present Invention | 1 | 22 | 22 | 1.2 | - | Balance |
| | 2 | 21.9 | 21.9 | 1.5 | - | Balance |
| | 3 | 21.8 | 21.8 | 2 | - | Balance |
| | 4 | 21.5 | 21.5 | 3 | - | Balance |
| | 5 | 21.1 | 21.1 | 5 | - | Balance |
| | 6 | 20.4 | 20.4 | 8 | - | Balance |
| | 7 | 20 | 20 | 10 | - | Balance |
| | 8 | 20.8 | 20.8 | 4 | B: 2.5 | Balance |
| | 9 | 20.2 | 20.2 | 5 | Al: 3.8 | Balance |
| | 10 | 19.8 | 19.8 | 8 | Si: 3.0 | Balance |
| | 11 | 20.9 | 20.9 | 4 | C: 2.0 | Balance |
| | 12 | 18.8 | 18.8 | 10 | Dy: 5.5 | Balance |
| | 13 | 19.7 | 19.7 | 7 | Tb: 1.5 | Balance |
| | 14 | 19.8 | 19.8 | 3 | Nd: 8.0 | Balance |
| | 15 | 20.3 | 20.3 | 5 | Sm: 3.5 | Balance |

**[Table 2]**

| Target | | Component Composition (Atomic%) | | | | |
|---|---|---|---|---|---|---|
| | | Ge | Sb | Ga | B, Al, C, Si, Lanthanoid Element | Te |
| Present Invention | 16 | 20 | 20 | 6 | Gd: 4.0 | Balance |
| | 17 | 20.9 | 20.9 | 3 | B: 0.5, Al: 1.0 | Balance |
| | 18 | 20.0 | 20.0 | 4 | Al: 5, C: 1 | Balance |
| | 19 | 20.2 | 20.2 | 5 | C: 1, Si: 5, Dy: 2 | Balance |
| | 20 | 19.8 | 19.8 | 2 | Sm: 2, Tb: 5, A1: 2 | Balance |
| | 21 | 19.0 | 19.0 | 7 | B:2, Si: 2, Dy: 0.5, Sm: 3 | Balance |
| Comparative | 1 | 22.1 | 21.1 | 0.3* | - | Balance |
| | 2 | 19.1 | 19.1 | 14* | - | Balance |
| | 3 | 17.3 | 17.3 | 9 | B: 13* | Balance |
| | 4 | 17.5 | 17.5 | 8 | Si: 13* | Balance |
| | 5 | 18.8 | 18.8 | 3 | Gd: 12* | Balance |

| | | | | | | |
|---|---|---|---|---|---|---|
| Asterisk (*) means a value out of the range of the present invention. | | | | | | |

**[Table 3]**

| Target | | Component Composition (Atomic%) | | | | |
|---|---|---|---|---|---|---|
| | | Ge | Sb | Ga | B, Al, C, Si, Lanthanoid Element | Te |
| Comparative | 6 | 17.8 | 17.8 | 5 | C: 15* | Balance |
| | 7 | 18.0 | 18.0 | 7 | Al: 12* | Balance |
| | 8 | 18.2 | 18.2 | 4 | Dy: 14* | Balance |
| | 9 | 18.7 | 18.7 | 2 | Nd: 14* | Balance |
| | 10 | 17.8 | 17.8 | 7 | Tb: 13* | Balance |
| Conventional Target 1 | | 22.2 | 22.2 | - | - | Balance |

| | | | | | | |
|---|---|---|---|---|---|---|
| Asterisk (*) means a value out of the range of the present invention. | | | | | | |

Next, each of the targets 1 to 21 according to the present invention, comparative targets 1 to 10, and conventional target 1 is bonded to a cooling backing plate made of copper, with an indium solder having a purity of 99.999% by weight. Then, the resulting targets are loaded into a direct-current magnetron sputtering apparatus within which the distance between the targets and substrates (Si wafers on the surface of each of which an SiO₂ film having a thickness of 100 nm is formed) is set to be 70 mm. Thereafter, the sputtering apparatus is vacuumed until the degree of an ultimate vacuum thereof becomes 5 x 10⁻⁵ Pa or less. Thereafter, the sputtering apparatus is supplied with Ar gas until the total pressure thereof become 1.0 Pa.
Substrate temperature: room temperature
Input power: 50 W (0.4 W/cm²)
Then, sputtering was performed under the above conditions, thereby forming phase change films 1 to 21, comparative phase change films 1 to 10, and conventional phase change film 1, which have a thickness of 300 nm and have component compositions as shown Tables 4 to 6 on the surfaces of the substrates.

The component compositions of the phase change films 1 to 21, comparative phase change films 1 to 10, and conventional phase change film 1, which were obtained in this way, were measured by an inductively coupled plasma (ICP) method. The results thereof are shown in Tables 4 to 6. Moreover, the phase change films 1 to 21 according to the present invention, conventional phase change films, and conventional phase change film 1, which were obtained, were kept and crystallized in a nitrogen flow at a temperature of 230°C for five minutes. Thereafter, electric resistivities were measured by a four-point probe method. Further, a film having a thickness of 3 µm was formed on a polycarbonate substrate having a diameter of 120 mm under the conditions described above. All of the formed film was peeled off and powderized. Then, the crystallization temperatures and melting points of the powered materials were measured under the following conditions: an Ar flow rate of 200 ml/min and a rising temperature of 10°C/min, by a differential thermal analysis (DTA) method. The results thereof are shown in Tables 4 to 6. In addition, the masses of samples used in this measurement are standardized as 15 mg. It should be noted herein that an exothermic peak appearing in the vicinity of 160 to 340°C is used as the crystallization temperature and an exothermic peak appearing in the vicinity of 540 to 620°C is used as the melting point.

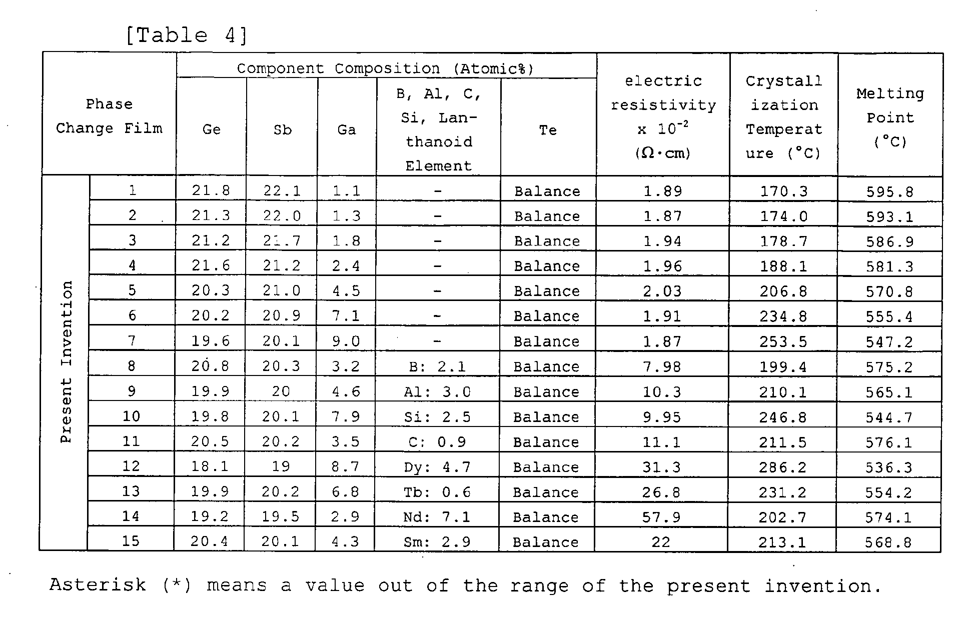

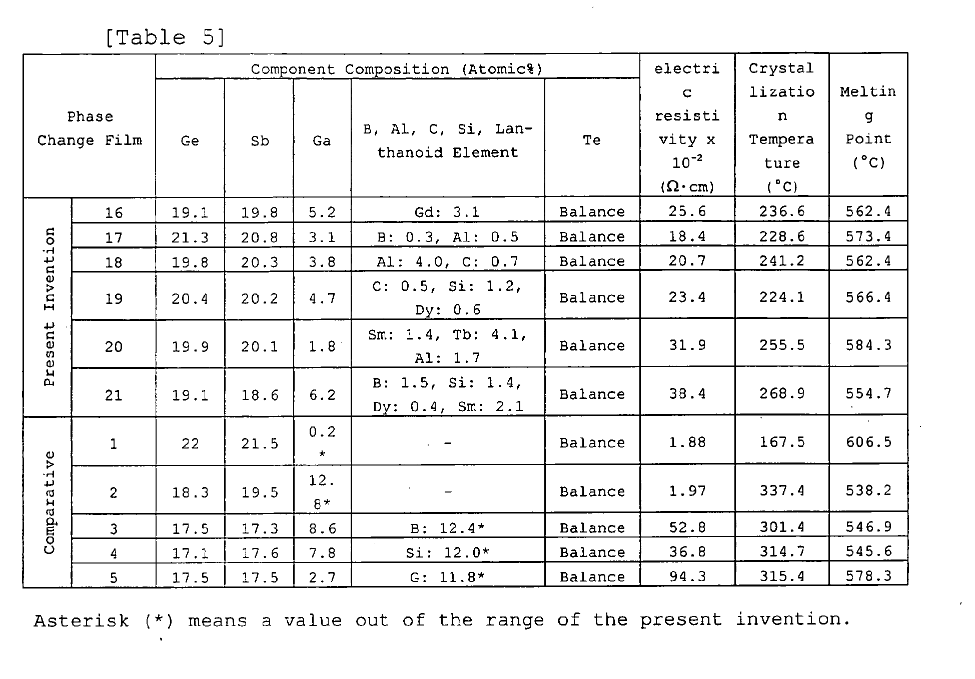

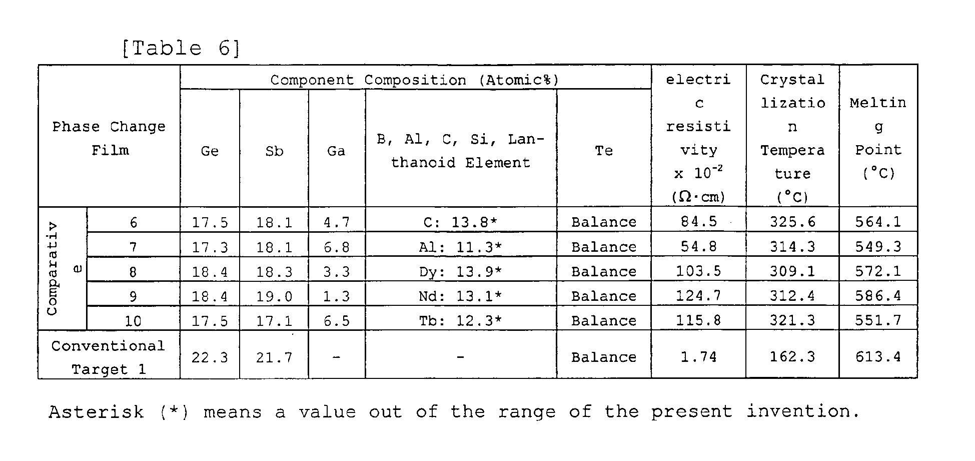

It can be understood from the results shown in Tables 4 to 6 that the crystallized phase change films 1 to 21 according to the present invention, which were obtained by performing sputtering using the targets 1 to 21 according to the present invention, are excellent phase change films having lower melting points and having little drop in electric resistivities, as compared with the conventional phase change film 1, which was obtained by performing sputtering using the conventional target 1. However, it can be understood that at least one unfavorable characteristic appears in the comparative phase change films 1 to 10 containing additive components out of the range of this invention.

## Claims

1. A phase change film for a semiconductor nonvolatile memory having a composition containing 10 to 25 atomic% of Ge, 10 to 25 atomic% of Sb, and 1 to 10 atomic% of Ga, with the balance being Te and inevitable impurities.

2. A phase change film for a semiconductor nonvolatile memory having a composition 10 to 25 atomic% of Ge, 10 to 25 atomic% of Sb, 1 to 10 atomic% of Ga, and a total of 10 atomic% or less of at least one or more elements selected from a group consisting of B, Al, C, Si and lanthanoid elements, with the balance being Te and inevitable impurities.

3. The phase change film for a semiconductor nonvolatile memory according to claim 2,
wherein the lanthanoid elements are at least one or more elements selected from a group consisting of Dy, Tb, Nd, Sm, and Gd.

4. The phase change film for a semiconductor nonvolatile memory according to any one of claims 1 to 3,
wherein the specific resistance of the film measured by a four probe method after crystallization is 5 x 10⁻³ to 5 x 10 Ω.cm, and the melting point of the film is 600°C or less.

5. A sputtering target for forming a phase change film for a semiconductor nonvolatile memory having a composition containing 10 to 26 atomic% of Ge, 10 to 26 atomic% of Sb, and 1 to 11 atomic% of Ga, with the balance being Te and inevitable impurities.

6. A sputtering target for forming a phase change film for a semiconductor nonvolatile memory having a composition 10 to 26 atomic% of Ge, 10 to 26 atomic% of Sb, 1 to 11 atomic% of Ga, and a total of 11 atomic% or less of at least one or more elements selected from a group consisting of B, Al, C, Si and lanthanoid elements, with the balance being Te and inevitable impurities.

7. The sputtering target for forming a phase change film for a semiconductor nonvolatile memory according to claim 6, wherein the lanthanoid elements are at least one or more elements selected from a group consisting of Dy, Tb, Nd, Sm, and Gd.
